Europäisches Patentamt

European Patent Office

Office européen des brevets

(11) Publication number: **0 225 992 B1**

# EUROPEAN PATENT SPECIFICATION

(45) Date of publication of patent specification: **13.03.91**   (51) Int. Cl.⁵: **H05K 13/02**, B65H 5/04

(21) Application number: **86114571.2**

(22) Date of filing: **21.10.86**

(54) **Apparatus for conveying a base of a printed circuit board.**

(30) Priority: **22.10.85 JP 236863/85**

(43) Date of publication of application:
**24.06.87 Bulletin 87/26**

(45) Publication of the grant of the patent:
**13.03.91 Bulletin 91/11**

(84) Designated Contracting States:
**CH DE FR GB IT LI SE**

(56) References cited:
**EP-A- 0 163 255**

(73) Proprietor: **SOMAR CORPORATION**
**11-2, Ginza 4-chome Chuo-ku**
**Tokyo 104(JP)**

(72) Inventor: **Sumi, Shigeo**
**8-11, Ayase**
**Hasuda-shi Saitama(JP)**
Inventor: **Matsuo, Takao**
**17-3-103, Karatodai 4-chome Kita-ku**
**Kobe-shi Hyogo(JP)**

(74) Representative: **Boeters, Hans Dietrich, Dr. et al**
**Boeters & Bauer Bereiteranger 15**
**W-8000 München 90(DE)**

**Description**

This invention relates to an apparatus for conveying a base as of a printed circuit board from an input position to a fixed clamping position.

Printed circuit boards for use in electronic equipment, e.g. computers, are such that a copper wiring or the like having a predetermined pattern is formed on a surface of an insulating base.

A printed circuit board of this sort is made by the following steps: A laminate consisting of a photosensitive resin layer (photoresist) and a translucent resin film (protective film) for protecting the photosensitive resin layer is bonded by thermocompression bonding onto a conductive layer provided on an insulating base. The thermocompression bonding is performed by a laminator on a mass-production basis. Then a wiring pattern film is superposed on the laminate and the photosensitive resin layer is exposed to light for a predetermined period of time, the light inciding through the wiring pattern film and the translucent resin film. The photosensitive resin layer thus exposed to light is developed to form an etching mask pattern after the translucent resin film has been peeled off by a peeling device. Unnecessary portions of the conductive layer are subsequently removed by etching and the remaining photosensitive resin layer is also removed to form a printed circuit board having a predetermined wiring pattern.

As mentioned before, during the process of manufacturing the printed circuit board, there is required the step of thermocompression bonding a laminate consisting of a photosensitive resin layer and a translucent resin film onto an insulating base having a conductive layer. To this end, in a respective film laminator, the laminate in the form of a thin film is pulled from a supply roller and then cut into pieces corresponding in dimensions to the base.

An apparatus of the kind here concerned is used for conveying the base to a thermocompression roller position in the laminator. This apparatus is equipped with a plurality of rollers usually consisting of a plurality of discs which are rotated to convey the base. When the base approaches the thermocompression rollers guide members guide the base crosswise toward a desired center line of the conveying path and cause the thermocompression rollers to pinch the base therebetween.

However, with conventional apparatus of this kind, even if the base is at first set exactly along the center line of the conveyance path, there is still a fear that the set position of the base would be offset from the desired position. Namely, when the base arrives at the thermocompression rollers, a part only of the base is clamped thereby so that the base may be deflected (forwardly or rearwardly, leftwardly or rightwardly, upwardly or downwardly) by the collision shock of the clamping, or the leading end of the base may be bent downwardly so that it is offset from the set laminating position for laminating the thin film onto the base.

The invention as claimed is intended to overcome these deficiencies. It solves the problem of precisely guiding the base up to the thermocompression roller position and for delivering it to the thermocompression rollers without any chance to then be deflected.

In the claimed apparatus, the base holding member temporarily fixes the base in place which has been fed to a predetermined press-clamping position without allowing the position of the base to be changed whereas the base support member supports the base at the proper level. In doing so the base support member may operate in cooperation with or independently of the base holding member.

By the operation of the base holding member and the base support member the position of the base is made to coincide with the set film bonding position of the laminator I. Needless to say that, when the base has been pinched between the thermocompression rollers, both, the base holding member and the base support member, are retracted.

In the following a preferred embodiment of the claimed invention is described in detail taking reference to the accompanying drawings. In these drawings

Fig. 1    is a perspective structural view of an apparatus according to the claimed invention;

Fig. 2    is a more scematic structural view of a film laminator related to an apparatus according to the claimed invention;

Fig. 3    is a sectional view taken along the line Y-Y of Fig. 1;

Fig. 4    is a perspective structural view of a crosswise base guide as shown in Fig. 3;

Fig. 5    is a side view showing in more detail the arrangement of base breadth detecting sensors, a base holding member and a base support member as principally shown in Fig. 1; and

Fig. 6    is a side view more completely showing the construction of the base support member of Figs. 1 and 5.

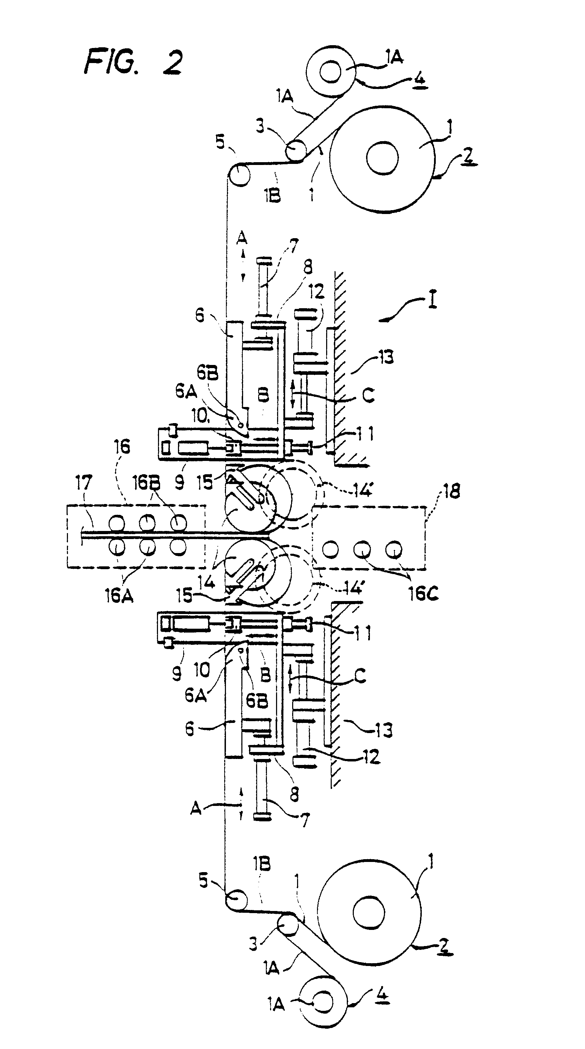

The film laminator I shown in Fig. 2 is designed to apply similar laminates of the kind described to both sides of a base, the base having conductive layers on both sides, accordingly.

In the film laminator I shown in Fig. 2 a three-layer laminate 1 consisting of a photosensitive resin layer and a translucent resin film is continuously drawn from each of an upper and a lower supply roller 2. The laminate 1 drawn from the supply roller 2 is separated by a peeling roller 3 into a translucent resin film (protective film) 1A and a remaining laminate 1B composed of the photosensitive resin layer with one side exposed (adhesive surface) and of the other translucent resin film. The translucent resin film 1A thus separated is so wound on a take-up roller 4.

The front end of the laminate 1B in the supply direction is sucked up a main vacuum plate 6 after passing a tension roller 5. The main vacuum plate 6 is supported by a frame 8 through an air cylinder 7 its position being thus variable in the direction of arrow A. An arcuate portion 6A at the front end of the main vacuum plate 6 constituting a part of means for clamping a base 17 under pressure contains a heater 6B and serves to attach the front end of the laminate 1B onto the conductive layer of the base 17 through thermocompression bonding. A rotary cutter 9 installed close to the arcuate portion 6A is used to cut the continuous laminate 1B into pieces corresponding in dimensions to the bases 17.

An auxiliary vacuum plate 10 assisting to have the front end of the laminate 1B thus cut off sucked to the arcuate portion 6A is positioned opposite to the rotary cutter 9. The auxiliary vacuum plate 10 is supported by the frame 8 through an air cylinder 11 its position being thus variable in the direction of arrow B. The frame 8 for supporting the main vacuum plate 6 and the auxiliary vacuum plate 10 is itself supported by a frame 13 of the laminator proper through an air cylinder 12 its position being thus variable in the direction of arrow C.

The laminate 1B whose front end is provisionally attached by the arcuate portion 6A to the conductive layer of the base 17 is thoroughly bonded by a thermocompression roller 14 which constitutes a part of the means for clamping the base under pressure. The thermocompression roller 14 at first bonds the front end of the laminate 1B onto the arcuate portion 6A through thermocompression bonding and then moves from a position shown by the dotted line marked with numeral 14' to the position shown by a solid line. The rear end of the laminate 1B cut to size by the rotary cutter 9 is guided by a triangular rotary vacuum plate 15 to prevent it from wrinkling before it is bonded by the thermocompression roller 14.

In the film laminator I so far described the base 17 is supplied and conveyed by the apparatus 16 of the present invention comprising conveyor rollers 16A and pressing rollers 16B. The base 17 with the laminate 1B bonded thereto is carried out of the laminator I by a base discharging device 18 including conveyor rollers 16C.

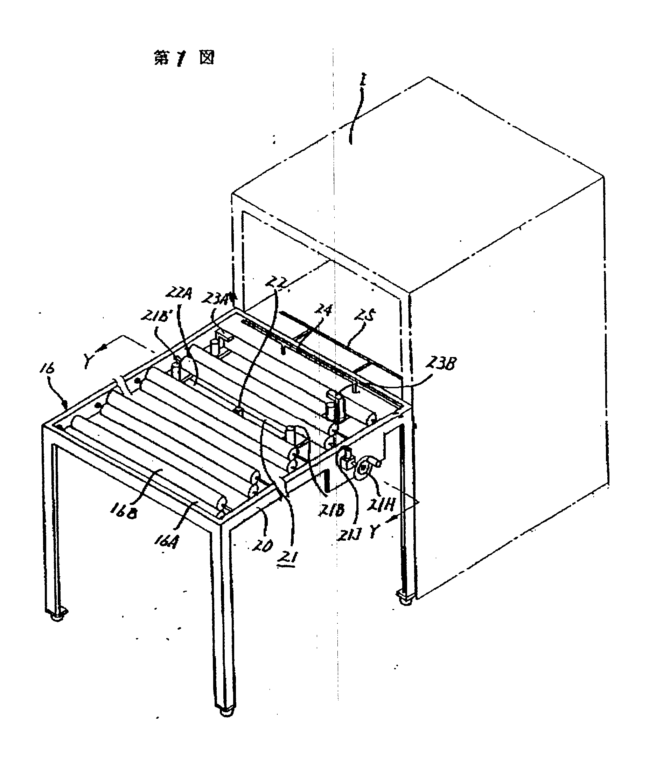

The apparatus 16 is coupled to the laminator I in the manner shown in Fig. 1. Each conveyor roller 16A is formed with a (solid or hollow: preferably hollow) fiber-reinforced plastic columnar member and a plurality of conveyor rollers 16A are rotatably fitted to a frame 20 of the apparatus 16. The conveyor rollers 16A are arranged close enough to prevent a thin base 17 from drooping. Every second of the conveyor rollers 16A or, alternatively, all of them are coupled to a driving source as occasion demands.

The base 17 is carried by the conveyor rollers 16A and conveyed while held in position by the pressing rollers 16B. Like the conveyor roller 16A the pressing rollers 16B, which are also rotatably fitted to the frame 20, may be formed, as a columnar member to keep a thin base 17 from warping and waving and thus from being caught by any rotary means. Although the pressing rollers 16B normally are not coupled to the driving source, they may be coupled thereto. When a base 17 is used which is not thin and tends to less warp and wave, the pressing rollers 16B may consist of a plurality of discoidal members.

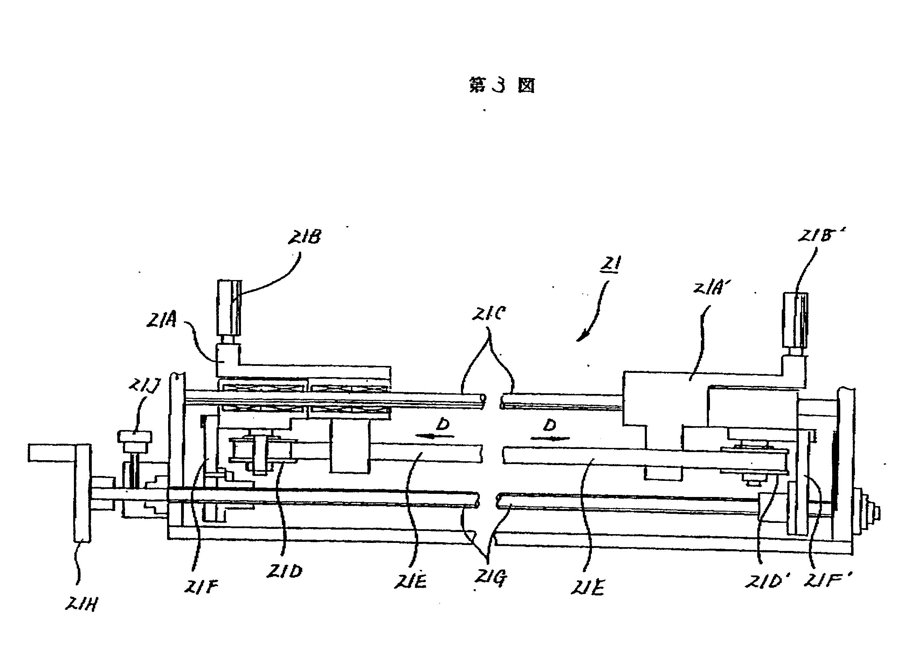

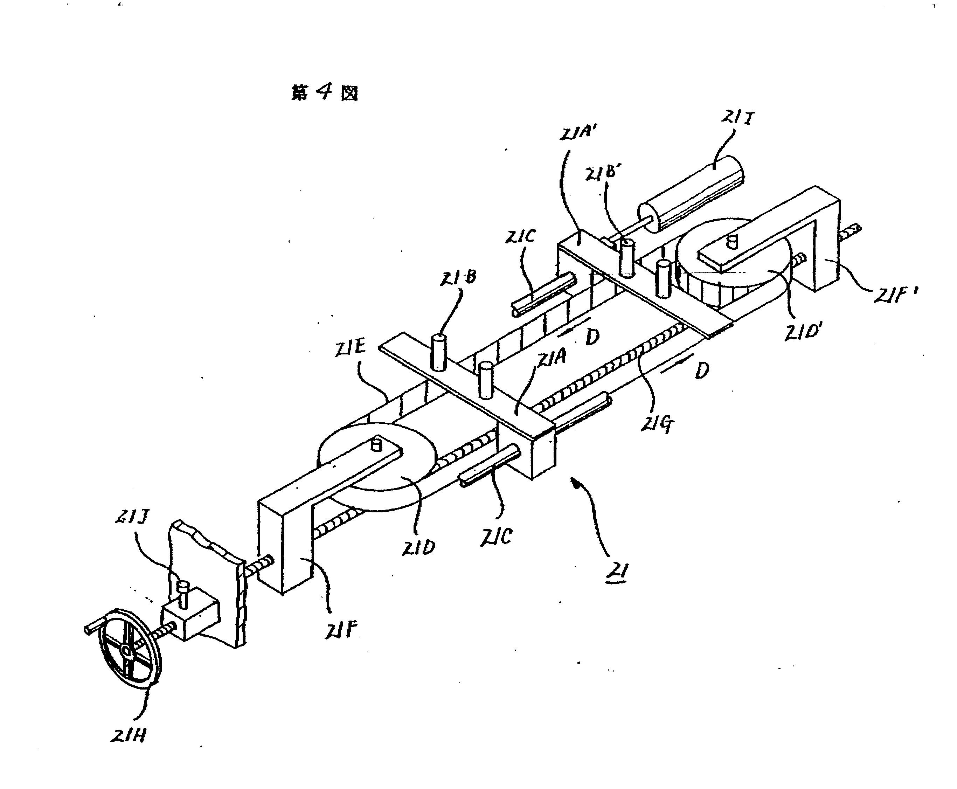

As shown in Fig. 3 (sectional view taken along line Y-Y) of Fig. 1 and Fig. 4 (perspective view), a crosswise base guide 21 comprises crosswise base guide members 21B, 21B' supported by support members 21A, 21A'. The support members 21A, 21A' are slidably fitted to a support rod 21C and attached to an endless belt 21E wound on pulleys 21D, 21D' in such a manner that they are moved towards each other when the endless belt 21E moves in the direction of arrow D. The support members 21A, 21A' are caused to slide along the support rod 21C by an air cylinder 21I installed on the support member 21A'.

The pulleys 21D, 21D' are supported by inverted L-shaped support members 21F, 21F', respectively. The inverted L-shaped support member 21F, 21F' mate with a threaded rod 21G, which is equipped with a handle 21H and, by turning the handle 21H, the inverted L-shaped support members 21F, 21F' are transversely moved while a fixed distance is maintained therebetween. The moving mechanism is intended to adjust the position of the crosswise base guide 21 to make the centerline in the conveyance direction of the base 17 coincide with the centerline in the conveyance direction of the laminate 1B for thermocompression bonding, i.e. the centerline of the apparatus 16 in case the former shifts from the latter. The position of the crosswise base guide 21 can be fixed by a screw 21J for preventing rotation of the threaded rod 21G.

A base position detecting sensor 22 (Fig.1) for detecting the front (or rear) end of a base 17 produces a signal for starting driving the crosswise base guide members 21B, 21B' of the crosswise base guide 21 towards each other. The base position detecting sensor 22 is fitted to the frame 20 through a support frame 22A. A reflective optical sensor is, for instance, employed as the base position detecting sensor 22.

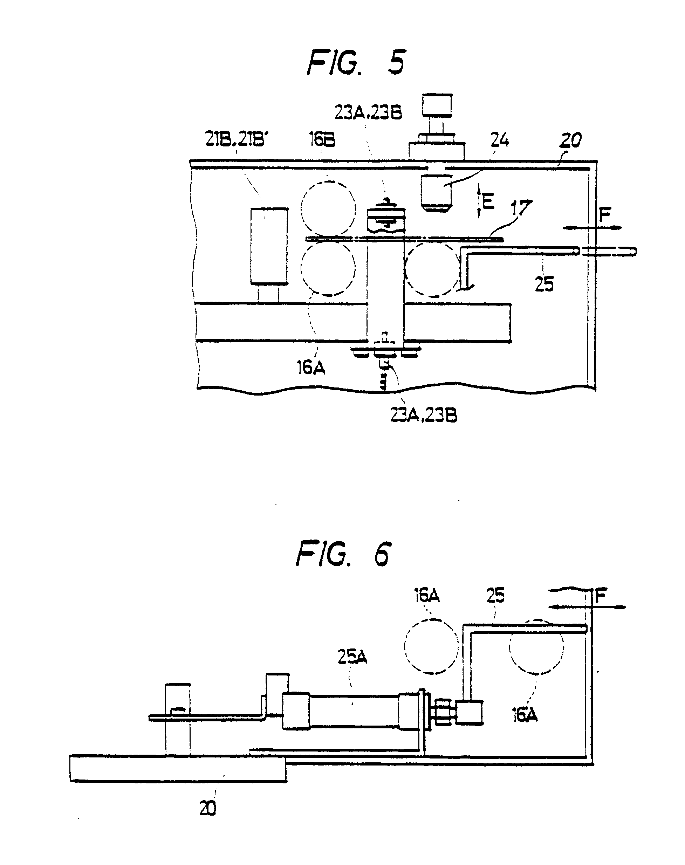

Base breadth detecting sensors 23A, 23B (Figs.1 and 5)for respectively detecting both sides of the base 17 produce signals for stopping driving the crosswise base guide members 21B, 21B' towards each other. The base breadth detecting sensors 23A, 23B are installed on the inner sides of the crosswise base guide members 21B, 21B' close to the front end in the conveyance direction of the support members 21A, 21A'. In other words, the base breadth detecting sensors 23A, 23B are installed in such a position as to stop the crosswise base guide members 21B, 21B' when the centerline of the base 17 coincides with the centerline of the apparatus 16. The control of the crosswise base guide 21 can simply be materialized by causing the signal for stopping drive of the crosswise base guide members 21B, 21B' to be produced slightly after the time where both sides of the base 17 have been detected by the base breadth detecting sensors 23A, 23B using a delay circuit. As the base breadth detecting sensors 23A, 23B, translucent type optical sensors can be used.

The base 17 can thus be conveyed to the starting position of thermocompression bonding readily and accurately in such a state that the centerline in the conveyance direction of the base 17 is made to coincide with the centerline in the conveyance direction of the apparatus 16 without allowing the base 17 to bend.

A base holding member 24 shown in Fig. 1 and 5 fixes and holds the base 17 so that it may not drop when it reaches the starting position of the thermocompression bonding. The base holding member 24 is fitted to the frame 20 and moved by an air cylinder and a spring (not shown) in the direction of arrow E. Additionally, a base support member 25 can be projected in the direction of arrow F interlockingly or not interlockingly with the operation of the base holding member 24. Control of the base support member 25 in the direction of arrow E is achieved by an air cylinder 25A (Fig.6) fitted to the frame 20. The operation of the base holding member 24 and or the base support member 25 is likewise controlled by the signal obtained from the base position detecting sensor 22.

The base holding member 24 and the base support member 25 thus installed support the base 17 to prevent it from dropping when it reaches the starting position of the thermocompression bonding and are capable of holding it in position until the thermocompression rollers vertically clamp it therebetween, so that the laminate 1B is accurately bonded onto the base 17.

The base support member 25 may be projected a predetermined period prior to and during the delivery of the base 17 to the thermocompression position. The base support member 25 should be provided as close as possible to the thermocompression position in order to assist the base delivery and the thermocompression operations.

Operation of the apparatus 16 will now briefly be described:

A base 17 is conveyed toward the thermocompression rollers 14 by driving the respective conveyor rollers 16A. When the front end of the base 17 thus conveyed is detected by the base position detecting sensor 22, the signal therefrom starts operation of the crosswise base guide 21. When both sides of the base 17 are then detected by the base breadth detecting sensors 23A, 23B, the operation of the crosswise base guide 21 is stopped. The base 17 is consequently conveyed to the position of thermocompression bonding in such a state that its centerline in the conveyance direction coincides with the centerline in the conveyance direction of the apparatus 16. Then the conveyor rollers 16A are stopped and the holding member 24 moves down and makes the base immovable. The base support member 25 simultaneously projects to support the base and prevent it from dropping. Then, as shown in Fig. 2, the thermocompression rollers 14 move the left and clamp the base inclusive the laminate or laminates 1B for thermocompression bonding.

## Claims

1. An apparatus for conveying a base (17) as of a printed circuit board from an input position to a fixed clamping position, comprising:
   - conveying means including a plurality of pairs of conveying and pressing rollers (16A, 16B) for conveying said base toward said clamping position,
   - a crosswise base guide (21) disposed in the path of said base along said conveying means between said input position and said clamping position for aligning the center line of said base extending in the conveying direction with a center line of said apparatus as said base is being conveyed by said conveying means,
   - a base holding member (24) for fixing said base in position immediately ahead of said clamping position, said conveying means then being arrested, and
   - a base support member (25) movable in said conveying direction for receiving and feeding said base from said fixed position to said clamping position when said holding member has been released.

2. The base conveying apparatus of claim 1 wherein said crosswise base guide (21) is adjustable in crosswise direction.

3. The base conveying apparatus of claim 1 or 2 wherein said crosswise base guide (21) is adjustable in latitude.

4. The base conveying apparatus of the claims 2 and 3 wherein said crosswise base guide (21) comprises:

   - a threaded rod (21G) extending generally perpendicular to said conveying direction of said base (17) and extending in a plane generally parallel to the plane of said base,
   - first and second pulley support members (21F, 21F') threadedly engaged with said threaded rod to move jointly in the same direction perpendicular to said conveying direction when said threaded rod is rotated,
   - a pulley (21D, 21D') rotatably mounted on each of said pulley support members (21F, 21F'), an endless belt (21E) being entrained between said pulleys,
   - a support rod (21C) mounted generally parallel to said threaded rod (21G),
   - a pair of guide member supports (21A, 21A') slidably mounted on said support rod (21C) and connected on opposite sides to said endless belt (21E) so that said guide member supports move toward or away from one another as said endless belt is moved, and
   - a pair of guide members (21B, 21B') mounted on respective ones of said guide member supports (21A, 21A') and disposed in said path of said base (17).

5. The base conveying apparatus of claim 4, further comprising and air cylinder (21I) connected to one of said guide member supports (21A, 21A') for moving both said guide members supports automatically through movement of said endless belt (21E).

6. The base conveying apparatus of claim 4 or 5, further comprising manual rotating means (21H) for said threaded rod (21G).

7. The base conveying apparatus of anyone of the preceding claims wherein said base holding member (24) is mounted above said path of said base (17) ahead of said clamping position and movable perpendicular to the plane of said path.

8. The base conveying apparatus of anyone of the preceding claims wherein said base supporting member (25) is arranged for supporting said base (17) from below and coupled to an air cylinder (25A) for movement in said conveying direction.

9. The base conveying apparatus of anyone of the preceding claims wherein one or more of said conveying means, said crosswise base guide (21), said base holding member (24), and said base support member (25) are automatically controlled by means of signals obtained from sensing means (22, 23A, 23B) arranged along said path of said base (17).

**Revendications**

1. Appareil de transport d'une base (17) telle qu'une carte de circuit imprimé, d'une position d'entrée à une position fixe de serrage, comprenant:

   - un dispositif de transport qui comprend plusieurs paires de rouleaux de transport et de pression (16A, 16B) destinés à transporter la base vers la position de serrage,
   - un guide transversal (21) de la base, placé sur le trajet de la base le long du trajet de transport entre la position d'entrée et la position de serrage et destiné à aligner l'axe central de la base, dans la direction de transport, sur un axe central de l'appareil lorsque la base est transportée par le dispositif transporteur,
   - un organe (24) de maintien de base destiné à fixer la base en position juste en avant de la position de serrage, le dispositif de transport étant alors arrêté, et
   - un organe (25) de support de base mobile dans la direction de transport et destiné à recevoir et faire avancer la base de la position fixe à la position de serrage lorsque l'organe de maintien a été libéré.

2. Appareil de transport de base selon la revendication 1, dans lequel le guide transversal (21) de la base est réglable en direction transversale.

3. Appareil de transport de base selon la revendication 1 ou 2, dans lequel le guide transversal (21) de la base est réglable en latitude.

4. Appareil de transport de base selon les revendications 2 et 3, dans lequel le guide transversal (21) de la base comporte:

    - une tige filetée (21G) d'orientation générale perpendiculaire à la direction de transport de la base (17) et disposée dans un plan parallèle de façon générale au plan de la base,

    - un premier et un second organe (21F, 21F') de support de poulie coopérant par vissage avec la tige filetée afin qu'ils se déplacent ensemble dans le même sens perpendiculairement à la direction de transport lorsque la tige filetée tourne,

    - une poulie (21D, 21D') montée afin qu'elle puisse tourner sur chacun des organes (21F, 21F') de support de poulie, une courroie sans fin (21E) étant entraînée entre les poulies,

    - une tige de support (21C) montée en direction générale parallèle à la tige filetée (21G),

    - deux supports (21A, 21A') d'organe de guidage, montés afin qu'ils puissent coulisser sur la tige de support (21C) et raccordés aux côtés opposés de la courroie sans fin (21E) afin que les supports d'organe de guidage se rapprochent l'un de l'autre ou s' écartent l'un de l'autre lorsque la courroie sans fin se déplace, et

    - deux organes de guidage (21B, 21B') montés sur les supports respectifs (21A, 21A') d'organe de guidage et disposés sur le trajet de la base (17).

5. Appareil de transport de base selon la revendication 4, comprenant en outre un vérin pneumatique (21I) raccordé à l'un des supports (21A, 21A') d'organe de guidage afin que les deux supports d'organe de guidage se déplacent automatiquement lors du déplacement de la courroie sans fin (21E).

6. Appareil de transport de base selon la revendication 4 ou 5, comprenant en outre un dispositif manuel (21H) d'entraînement en rotation de la tige filetée (21G).

7. Appareil de transport de base selon l'une quelconque des revendications précédentes, dans lequel l'organe (24) de maintien de base est monté au-dessus du trajet de la base (17) en amont de la position de serrage et est mobile perpendiculairement au plan de ce trajet.

8. Appareil de transport de base selon l'une quelconque des revendications précédentes, dans lequel l'organe (25) de support de base est destiné à supporter la base (17) par-dessous et est couplé à un vérin pneumatique (25A) afin qu'il se déplace dans la direction de transport.

9. Appareil de transport de base selon l'une quelconque des revendications précédentes, dans lequel un ou plusieurs des dispositifs transporteurs, du guide transversal (21) de la base, de l'organe (24) de maintien de base et de l'organe (25) de support de base sont commandés automatiquement par des signaux provenant de dispositifs capteurs (22, 23A, 23B) placés le long du trajet de la base (17).

**Ansprüche**

1. Vorrichtung zum Transportieren einer Basis (17) wie z.B. einer solchen einer gedruckten Schaltungsplatte von einer Eingabeposition zu einer festgelegten Klemmposition, enthaltend:

    - Fordermittel mit einer Mehrzahl paarweise angeordneter Transport- und Andruckrollen (16A 16B) zum Transportieren der Basis gegen die Klemmposition,

    - eine transversale Basisführung (21) an der Bahn der Basis entlang den Fördermitteln zwischen der Eingabe- und der Klemmposition zum Gegeneinander-Ausrichten der Mittellinie der Basis in der Förderrichtung und einer Mittellinie der Vorrichtung beim Transport der Basis durch die Fördermittel,

    - ein Basishalteglied (24) zum Festhalten der Basis in Position unmittelbar vor der Klemmposition, wobei die Fördermittel unterdessen stillgesetzt sind, und

    - ein in der Förderrichtung bewegliches Basisstützglied (25) zum Aufnehmen und Weitergeben der Basis aus der Festhalteposition zu der Klemmposition, nachdem das Halteglied freigegeben wurde.

2. Basistransportvorrichtung nach Anspruch 1, worin die transversale Basisführung (21) in transversaler Richtung einstellbar ist.

3. Basistransportvorrichtung nach Anspruch 1 oder 2, worin die transversale Basisfuhrung (21) in der Breite einstellbar ist.

4. Basistransnortvorrichtung nach den Ansprüchen 2 und 3, worin die transversale Basisführung (21 ) folgendes enthält:

    - eine Gewindespindel (21G), die im wesentlichen senkrecht zu der Förderrichtung der Basis (17) und in einer im wesentlichen zu derjenigen der Basis parallelen Ebene) verläuft,

    - erste und zweite Riemenscheibenlagerglieder (21F, 21F'), die mit der Gewindespindel in Gewindeeingriff stehen, um sich gemeinsam in der gleichen Richtung senkrecht zu der Förderrichtung zu bewegen, wenn die Gewindespindel gedreht wird,

- Je eine auf jedem der Riemenscheibenlagerglieder (21F, 21F') drehbar gelagerte Riemenscheibe (21D, 21D'), wobei ein endloser Riemen (21E) über die Riemenscheiben geführt ist,

- eine im wesentlichen parallel zu der Gewindespindel (21G) angeordnete Tragstange (21C),

- ein Paar Führungsgliedlager (21A, 21A'), die gleitfähig auf der Tragstange (21C) gelagert und auf gegenüberliegenden Seiten mit dem endlosen Riemen (21E) verbunden sind, so daß sie sich beim Bewegen des endlosen Riemens gegeneinander oder voneinander weg bewegen, und

- zwei auf je einem der Führungsgliedlager (21A, 21A') gelagerte und an der Bahn der Basis (17) angeordnete Führungsglieder (21B, 21B').

5. Basistransportvorrichtung nach Anspruch 4, des weiteren enthaltend einen Luftzylinder (21I) verbunden mit einem der Führungsgliedlager (21A, 21A') zum automatischen Bewegen der beiden Führungsgliedlager durch Bewegen des endlosen Riemens (21E).

6. Basistransportvorrichtung nach Anspruch 4 oder 5, des weiteren enthaltend eine manuelle Drehvorrichtung (21H) für die Gewindespindel (21G).

7. Basistransportvorrichtung nach einem der vorhergehenden Ansprüche, wobei das Basishalteglied (24) oberhalb der Bahn der Basis (17) vor der Klemmposition angeordnet und senkrecht zu der Ebene der Bahn beweglich ist.

8. Basistransportvorrichtung nach einem der vorhergehenden Ansprüche, wobei das Basisstützglied (25) zum Abstützen der Basis (17) von unten angeordnet und mit einem Luftzylinder (25A) zum Bewegen in der Förderrichtung verbunden ist.

9. Basistransportvorrichtung nach einem der vorhergehenden Ansprüche, wobei eines oder mehrere der Fördermittel, die transversale Basisführung (21), das Basishalteglied (24) und das Basisstützglied (25) durch Signale aus an der Bahn der Basis (17) angeordneten Fühlmitteln (22, 23A, 23B) automatisch gesteuert sind.

第 1 図

# FIG. 2

第 3 図

第 4 図

## FIG. 5

## FIG. 6